Europäisches Patentamt

**European Patent Office**

**Office européen des brevets**

(19)

(11) Numéro de publication: **0 250 292 B1**

# FASCICULE DE BREVET EUROPEEN

(12)

(45) Date de publication de fascicule du brevet:
**29.01.92**

(51) Int. Cl.⁵: **G01R 29/10**

(21) Numéro de dépôt: **87401287.5**

(22) Date de dépôt: **09.06.87**

(54) **Sonde perturbatrice de courant à boucle résonnante.**

(30) Priorité: **10.06.86 FR 8608363**

(43) Date de publication de la demande:
**23.12.87 Bulletin 87/52**

(45) Mention de la délivrance du brevet:
**29.01.92 Bulletin 92/05**

(84) Etats contractants désignés:
**DE GB NL SE**

(56) Documents cités:
**US-A- 1 781 363**

**PROCEEDINGS OF THE INSTITUTION OF ELECTRICAL ENGINEERS, vol. 110, no. 10, octobre 1963, pages 1747-1754, IEEE, New York, US; K. IIZUKA: "Photoconductive probe for measuring electromagnetic fields"**

**L'ONDE ELECTRIOUE, vol. 62, no. 5, mai 1982, pages 73-78, FR; J.Ch. BOLOMEY: "La méthode de diffusion modulée: une approche au relevé des cartes de champs microondes en temps réel"**

(73) Titulaire: **ETABLISSEMENT PUBLIC DE DIFFU-SION dit "TELEDIFFUSION DE FRANCE"**
**10, rue d'Oradour sur Glane**
**F-75932 Paris Cédex 15(FR)**

Titulaire: **ETAT FRANCAIS représenté par le Ministre des PTT (Centre National d'Etudes des Télécommunications)**
**38-40 rue du Général Leclerc**
**F-92131 Issy-les-Moulineaux(FR)**

(72) Inventeur: **Piole, Philippe**
**51, Square Marcel Henri Lebouc**
**F-35700 Rennes(FR)**

(74) Mandataire: **Mongrédien, André et al**
**c/o BREVATOME 25, rue de Ponthieu**
**F-75008 Paris(FR)**

## Description

La présente invention a pour objet une sonde perturbatrice de courant à boucle résonnante. Elle trouve une application notamment dans la mesure de la distribution du courant le long d'une antenne, en particulier dans la méthode dite du rayonnement en retour modulé.

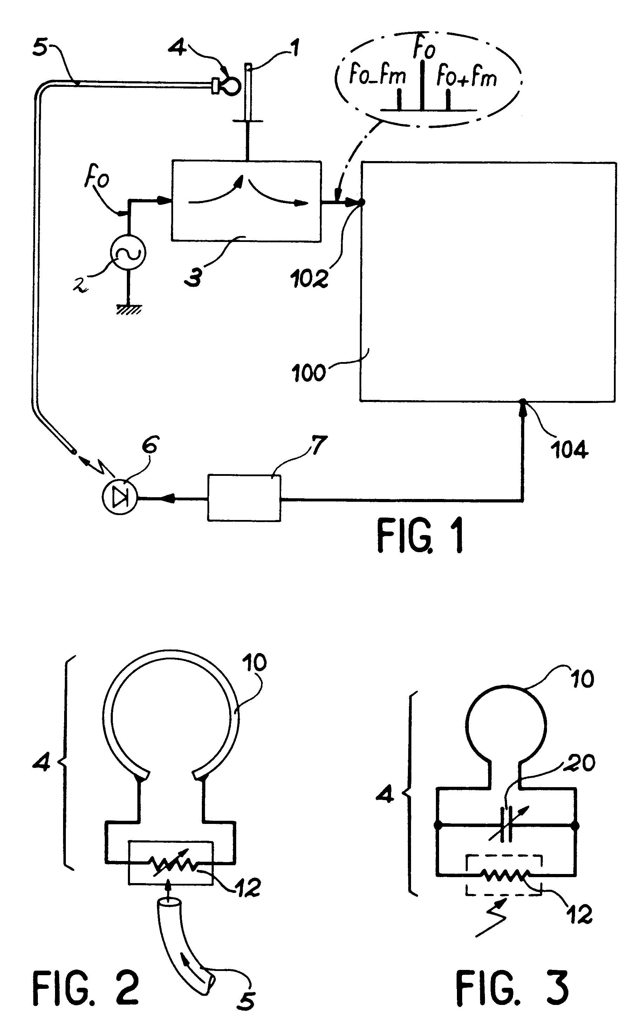

La figure 1 annexée illustre cette méthode.

Une antenne 1 est alimentée par un générateur 2, à travers un circulateur 3 (ou T hybride ou coupleur). La fréquence de travail est fo. Une petite sonde 4, formée d'une ou plusieurs spire(s) conductrice(s) fermée(s) sur une photorésistance, est déplacée le long de l'antenne. La photorésistance de la sonde est éclairée par un rayonnement lumineux guidé par une fibre optique 5 alimentée par une diode électroluminescente 6. Celle-ci est commandée par un circuit 7 comprenant un oscillateur à une fréquence fm. Le rayonnement lumineux ainsi modulé en amplitude à la fréquence fm provoque une variation de résistance de la photorésistance insérée dans la sonde. La sonde est couplée avec le champ magnétique produit par le courant circulant dans l'antenne, de sorte que le signal électrique réfléchi par l'antenne se trouve modulé en amplitude à la fréquence fm. Le spectre du signal réfléchi est donc formé par une porteuse à la fréquence fo et par deux bandes latérales aux fréquences fo-fm et fo + fm. Un tel signal véhicule les informations d'amplitude et de phase relatives au courant circulant dans l'antenne au droit de la sonde. Un circuit 100 permet de lire ces informations.

Le principe d'une telle méthode est décrite, par exemple, dans l'article de K.IIZUKA intitulé "Photoconductive Probe For Measuring Electromagnetic Fields" publié dans Proceedings of the IEE, vol.110, n°10, Octobre 1963.

Un exemple de circuit 100 est décrit dans la demande de brevet européen n° 0 248 737, publiée 9.12.87 et déposée par les présents demandeurs, pour "Circuit d'analyse d'un signal électrique modulé en amplitude, comprenant un transposeur de fréquence".

La figure 2 annexée montre de manière plus détaillée la structure de la sonde 4. On y voit une boucle 10, une photorésistance 12 et la fibre optique 5 déjà mentionnée.

Bien que donnant satisfaction à certains égards, une telle sonde manque de sensibilité. Le but de la présente invention est de remédier à cet inconvénient. Ceci est obtenu en rendant la sonde résonnante. Pour cela, un condensateur réglable est connecté à la boucle et ajusté à une valeur telle que l'ensemble boucle-condensateur forme un circuit résonnant pour la fréquence du courant circulant dans l'antenne, c'est-à-dire, dans l'exemple de la figure 1, pour la fréquence fo. Il en résulte une meilleure sensibilité, comme on le comprendra mieux par la suite. La sonde peut alors être réduite dans ses dimensions.

L'invention a également pour objet un autre perfectionnement qui se combine au précédent et qui consiste à blinder la sonde.

Enfin, un dernier perfectionnement permet encore d'améliorer la sensibilité de la sonde : il consiste à exciter la diode électroluminescente non pas par un signal carré, mais par un signal impulsionnel dont on fait varier le rapport cyclique en lui donnant une valeur différente de 1/2 (qui correspond au signal carré). Les performances de la photorésistance s'en trouvent encore améliorées.

De toute façon, on comprendra mieux les caractéristiques et avantages de l'invention à la lumière de la description qui va suivre. Cette description se réfère à des dessins annexés sur lesquels :

- la figure 1, déjà décrite, illustre la méthode dite du rayonnement en retour modulé,
- la figure 2, déjà décrite, montre une sonde apériodique selon l'art antérieur,
- la figure 3 montre le schéma électrique équivalent de la sonde de l'invention,
- la figure 4 montre la variation de surtension de la sonde selon l'invention en fonction de la fréquence,
- la figure 5 montre la constitution de la sonde,
- la figure 6 illustre un moyen de commande de la diode électroluminescente.

Le schéma électrique de la figure 3 montre une boucle 10 fermée sur une photorésistance 12, et un condensateur réglable 20. L'ensemble boucle-condensateur forme un circuit LC résonnant. Il est réglé pour être résonnant à la fréquence de travail fo.

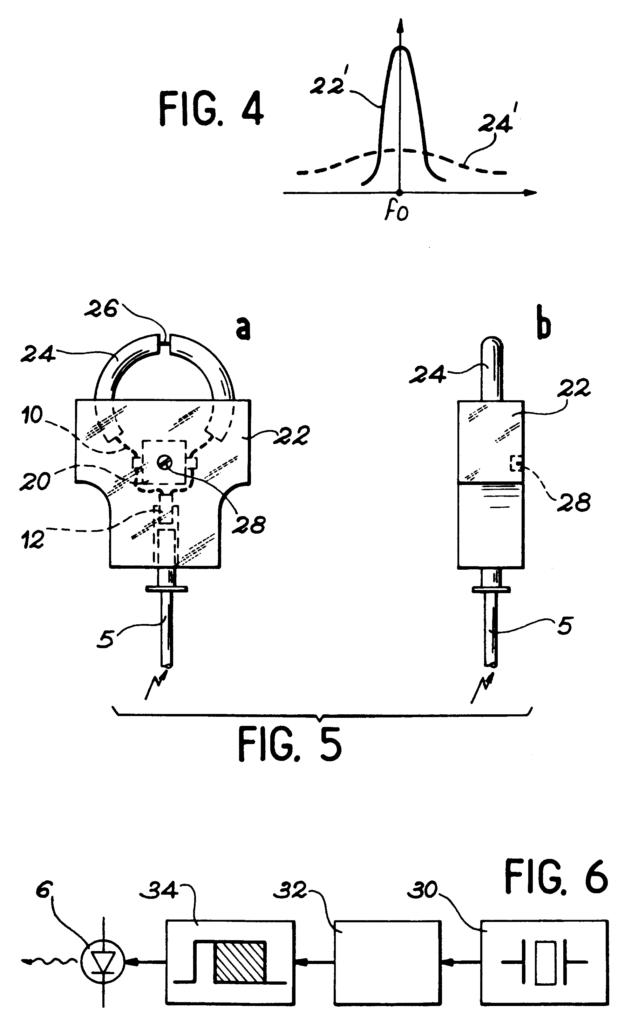

La figure 4 montre la variation de surtension de ce circuit en fonction de la fréquence. Cette surtension passe par un maximum pour la fréquence de résonnance fo et décroît de part et d'autre de cette valeur. Lorsqu'aucune lumière ne vient frapper la photorésistance, celle-ci présente une résistance élevée et le circuit est très surtendu : on obtient la courbe 22'. En revanche, lorsque la photorésistance est éclairée, sa résistance chute et la surtension baisse : on obtient la courbe 24'. Ainsi, à fréquence fixe, la modulation de l'éclairement de la photorésistance se traduit par une variation considérable de la surtension et, en conséquence, par une modulation de la perturbation magnétique engendrée par la sonde. Lorsque la sonde est apériodique comme dans l'art antérieur, son influence sur l'antenne varie beaucoup moins lorsque l'éclairement de la photorésistance change. On gagne donc considérablement en sensibilité en rendant la sonde résonnante.

La figure 5 montre un mode de réalisation de la sonde. Celle-ci est représentée de face sur la partie a et de profil sur la partie b. On y retrouve la boucle 10, la photorésistance 12, la fibre optique 5 et le condensateur réglable 20. En outre, on y voit un blindage 22 entourant le condensateur et la moitié inférieure de la boucle. Celle-ci est par ailleurs blindée sur son autre moitié par une gaine 24, laquelle est percée d'une fente 26 qui permet au champ magnétique de pénétrer dans la boucle. Le condensateur 20 est accessible de l'extérieur grâce à un trou 28 percé dans le blindage.

Pour fonctionner dans la gamme 150-250 MHz, la boucle a par exemple un diamètre de 15 mm, soit environ X/100.

Pour exciter la diode électroluminescente, on peut avantageusement utiliser un circuit comme ce lui de la figure 6. Un oscillateur à quartz 30 travaille par exemple à 2 MHz. Il est suivi d'un diviseur 32, par exemple par 4096, ce qui permet d'obtenir un train d'impulsions d'une fréquence de répétition égale à environ 488 Hz. Un circuit 34 permet de faire varier le rapport cyclique de ce signal et d'optimiser la réponse de la photorésistance. En effet, la réponse de celle-ci diminue lorsque la fréquence de modulation augmente, cause du temps de migration des porteurs dans le photoconducteur. On évite la saturation du photoconducteur en limitant le temps d'illumination. On gagne donc encore en sensibilité par ce moyen de commande.

## Revendications

1. Sonde perturbatrice de courant comprenant au moins une boucle conductrice (10) fermée sur une photorésistance (12), une diode électroluminescente (6) couplée optiquement à la photorésistance (12) par une fibre optique (5), et un circuit de commande de la diode (7), cette sonde étant caractérisée par le fait qu'elle comprend en outre un condensateur réglable (20) connecté en parallèle sur la boucle (10), l'ensemble boucle-condensateur formant un circuit résonnant, le condensateur (20) étant réglé pour que ce circuit soit résonnant à la fréquence (fo) du courant à perturber.

2. Sonde selon la revendication 1, caractérisée par le fait qu'elle comprend un blindage (22) autour de la boucle (10) et du condensateur (20) avec une ouverture (26) de faible largeur autour de la boucle (10).

3. Sonde selon la revendication 1, caractérisée par le fait que le circuit de commande (30, 32, 34) de la diode électroluminescente (6) délivre à celle-ci un signal impulsionnel à rapport cyclique réglable.

## Claims

1. Current disturbing probe comprising at least one conductive loop (10) closed on a photoresistor (12), a light-emitting diode (6) optically coupled to the photoresistor (12) by an optical fibre (5) and a control circuit for said diode (7), characterized in that the probe also comprises a variable capacitor (20) connected in parallel to the loop (10), the loop-capacitor assembly forming a resonant circuit, the capacitor (20) being adjusted in such a way that the circuit resonates at the frequency (fo) of the current to be disturbed.

2. Probe according to claim 1, characterized in that it comprises a shield (22) around the loop (10) and the capacitor (20) with a small width opening (26) around the loop (10).

3. Probe according to claim 1, characterized in that the control circuit (30, 32, 34) of the light-emitting diode (6) supplied the latter with a pulse signal with a variable cyclic ratio.

## Patentansprüche

1. Den Strom störende Sonde mit wenigstens einem leitfähigen Bügel (10) der über einem Photowiderstand (12) geschlossen ist, und einer Elektrolumineszenzdiode (6), die optisch über eine optische Faser (5) mit dem Photowiderstand (12) verbunden ist, wobei diese Sonde gekennzeichnet ist durch die Tatsache, daß sie außerdem einen regelbaren Kondensator (20) umfaßt, der auf dem Bügel parallel angeschlossen ist, wobei die Anordnung Bügel-Kondensator einen Resonanzschaltkreis bildet, wobei der Kondensator (20) so geregelt wird, daß der Schaltkreis die Resonanzfrequenz (f0) des zu störenden Stroms besitzt.

2. Sonde nach Anspruch 1, gekennzeichnet durch die Tatsache, daß sie eine Abschirmung (22) um den Bügel (10) und den Kondensator (20) mit einer Öffnung (26) geringer Breite um den Bügel (10) besitzt.

3. Sonde nach Anspruch 1, gekennzeichnet durch die Tatsache, daß der Steuerungsschaltkreis (30, 32, 34) für die Elektrolumineszenzdiode (6) an diese ein Impulssignal mit einem regelbaren Zyklusverhältnis anlegt.

**FIG. 1**

**FIG. 2**

**FIG. 3**

FIG. 4

FIG. 5

FIG. 6